(19) Europäisches Patentamt
European Patent Office
Office européen des brevets

(11) EP 2 437 287 A1

(12) EUROPEAN PATENT APPLICATION
published in accordance with Art. 153(4) EPC

(43) Date of publication:
04.04.2012 Bulletin 2012/14

(51) Int Cl.:
H01L 21/329 (2006.01)  H01L 29/861 (2006.01)

(21) Application number: 09845213.9

(86) International application number:
PCT/JP2009/059759

(22) Date of filing: 28.05.2009

(87) International publication number:
WO 2010/137146 (02.12.2010 Gazette 2010/48)

(84) Designated Contracting States:
AT BE BG CH CY CZ DE DK EE ES FI FR GB GR
HR HU IE IS IT LI LT LU LV MC MK MT NL NO PL
PT RO SE SI SK TR

(71) Applicant: Toyota Jidosha Kabushiki Kaisha
Toyota-shi, Aichi 471-8571 (JP)

(72) Inventors:
• MISUMI Tadashi
Toyota-shi
Aichi 471-8571 (JP)

• HAMADA Kimimori
Toyota-shi
Aichi 471-8571 (JP)

(74) Representative: TBK
Bavariaring 4-6
80336 München (DE)

(54) **METHOD FOR PRODUCING DIODE, AND DIODE**

(57) The present specification provides a method of efficiently manufacturing diodes in which recovery surge voltage is hardly generated.

The method manufactures a diode including a high concentration n-type semiconductor layer, a medium concentration n-type semiconductor layer formed on the high concentration n-type semiconductor layer, a low concentration n-type semiconductor layer formed on the medium concentration n-type semiconductor layer, and a p-type semiconductor layer formed on the low concentration n-type semiconductor layer. This manufacturing method includes growing the low concentration n-type semiconductor layer on an n-type semiconductor substrate by epitaxial growth, wherein a concentration of n-type impurities in the low concentration n-type semiconductor layer is lower than that in the n-type semiconductor substrate, and forming the high concentration n-type semiconductor layer by injecting n-type impurities to a lower surface of the n-type semiconductor substrate.

FIG. 1

**Description**

TECHNICAL FIELD

The present application relates to a method of manufacturing a diode, and the diode.

BACKGROUND ART

When a diode is switched from a state where forward voltage is applied to a state where reverse voltage is applied, a depletion layer spreads from a p-n junction to an n-type semiconductor layer. Then carriers existing in the n-type semiconductor layer are rapidly exhausted because of the depletion layer, hence high reverse current flows in the diode in a short time, and high surge voltage is generated. This surge voltage is generally called "recovery surge voltage".

Japanese Patent Application Laid-Open No. 2000-228404 discloses a diode comprising a high concentration n-type semiconductor layer, a medium concentration n-type semiconductor layer formed on the high concentration n-type semiconductor layer, a low concentration n-type semiconductor layer formed on the medium concentration n-type semiconductor layer, and a p-type semiconductor layer formed on the low concentration n-type semiconductor layer. When this diode is switched from the state where the forward voltage is applied to the state where the reverse voltage applied, the spread of a depletion layer stops at the medium concentration n-type semiconductor layer, since a concentration of n-type impurities of the medium concentration n-type semiconductor layer is relatively high. In other words, the medium concentration n-type semiconductor layer is partially depleted, but is not completely depleted. Therefore, the carriers remain in the medium concentration n-type semiconductor layer which is not depleted, and the rapid exhaustion of the carriers is suppressed. As a consequence, the recovery surge voltage decreases.

SUMMARY OF INVENTION

TECHNICAL PROBLEM

Japanese Patent Application Laid-Open No. 2000-228404 discloses two methods of manufacturing the above mentioned diode.

According to a first manufacturing method, the medium concentration n-type semiconductor layer and the low concentration n-type semiconductor layer are grown on a semiconductor substrate, which corresponds to the high concentration n-type semiconductor layer, by epitaxial growth. However, in a case of growing both the medium concentration n-type semiconductor layer and the low concentration n-type semiconductor layer by the epitaxial growth, a very thick layer is grown by the epitaxial growth. It takes a long time to form a thick layer by the epitaxial growth. Furthermore, if a thick layer is formed by the epitaxial growth, crystal defects, such as slippage, are easily generated, and the manufacturing yield drops. Consequently, according to the first manufacturing method, diodes cannot be manufactured efficiently.

According to a second manufacturing method, n-type impurities are injected to the semiconductor substrate, which corresponds to the low concentration n-type semiconductor layer, to form the medium concentration n-type semiconductor layer and the high concentration n-type semiconductor layer. However, it is difficult to form the thick medium concentration n-type semiconductor layer by ion injection. If the thickness of the medium concentration n-type semiconductor layer is thin, the recovery surge voltage does not decrease. If the quantity of the n-type impurities to be injected is increased and the thermal diffusion time of the impurities is increased, the medium concentration n-type semiconductor region can be formed to be thick. But if the medium concentration n-type semiconductor layer is formed to be thick in this manner, it takes time to manufacture a diode.

The present specification provides a method of efficiently manufacturing a diode of which recovery surge voltage is hardly generated.

SOLUTION TO PROBLEM

According to a first manufacturing method provided by the present specification, a diode including: a high concentration n-type semiconductor layer; a medium concentration n-type semiconductor layer formed on the high concentration n-type semiconductor layer; a low concentration n-type semiconductor layer formed on the medium concentration n-type semiconductor layer; and a p-type semiconductor layer formed on the low concentration n-type semiconductor layer, is manufactured. The manufacturing method includes: growing the low concentration n-type semiconductor layer on an n-type semiconductor substrate by epitaxial growth, wherein a concentration of n-type impurities in the low concentration n-type semiconductor layer is lower than that in the n-type semiconductor substrate; and forming the high concentration n-type semiconductor layer by injecting n-type impurities to a lower surface of the n-type semiconductor substrate.

In the first manufacturing method, it does not matter which of the step of growing the low concentration n-type semiconductor layer or the step of forming the high concentration n-type semiconductor is executed first. The p-type semiconductor layer may be formed by either epitaxial growth or impurity injection. The step of forming the p-type semiconductor layer must be executed after the step of forming the low concentration n-type semiconductor layer, but may be executed before the step of forming the high concentration n-type semiconductor layer or may be executed after this step.

In the first manufacturing method, the low concentration n-type semiconductor layer is grown on the n-type semiconductor substrate by the epitaxial growth.

Since the layer to be grown by the epitaxial growth is one, the epitaxial growth does not take a long time. The high concentration n-type semiconductor layer is formed by injecting n-type impurities to the n-type semiconductor substrate. The high concentration n-type semiconductor layer, which need not be formed to be thick, can be formed appropriately by injecting the n-type impurities. A region in the n-type semiconductor substrate that is other than the high concentration n-type semiconductor layer becomes the medium concentration n-type semiconductor layer, in which the concentration of n-type impurities is higher than that of the low concentration n-type semiconductor layer, and in which the concentration of n-type impurities is lower than that of the high concentration n-type semiconductor layer. The thickness of the medium concentration n-type semiconductor layer is determined depending on the thickness of the n-type semiconductor substrate to be used. Therefore, it is easy to increase the thickness of the medium concentration n-type semiconductor layer. As described above, according to the first manufacturing method, the medium concentration n-type semiconductor layer can be formed to be thick, and a diode in which recovery surge voltage is hardly generated can be manufactured. Further, according to the first manufacturing method, it is unnecessary to perform the epitaxial growth and the n-type impurity injection for a long time, hence diodes can be manufactured efficiently.

In the case of the above mentioned first manufacturing method, however, variation in characteristics tends to be generated among the diodes to be manufactured. In the diode manufactured by the first manufacturing method, the medium concentration n-type semiconductor layer is formed using the n-type semiconductor substrate. Generally, the manufacturing variation in the concentration of n-type impurities in the n-type semiconductor substrate is large. In the case of an ingot manufactured by a Cz method, for example, the concentration of n-type impurities changes along the pulling direction of the ingot. Therefore, the manufacturing variation in the concentration of n-type impurities is large in the n-type semiconductor substrates, which are sliced from the ingot. In the case of an n-type semiconductor substrate manufactured by an Fz method, the concentration of n-type impurities differs depending on a position in the n-type semiconductor substrate. Since a variation resides in the concentration of n-type impurities in the n-type semiconductor substrate, as described above, variation in the concentration of n-type impurities in the medium concentration n-type semiconductor layer is also large. If the variation in the n-type impurity concentration of the medium concentration n-type semiconductor layer is large, a range of a depletion layer spreading in the medium concentration n-type semiconductor layer varies. Consequently, among the diodes to be manufactured, the carrier exhaustion speed varies, and the magnitude of the recovery surge voltage, which is generated when reverse voltage is applied, also varies. In other words, characteristics of the recovery surge voltage vary depending on the diode. Therefore the present specification provides a second manufacturing method for suppressing the variation in the characteristics of the recovery surge voltage.

According to a second manufacturing method, a diode including: a high concentration n-type semiconductor layer; a first medium concentration n-type semiconductor layer formed on the high concentration n-type semiconductor layer; a second medium concentration n-type semiconductor layer formed on the first medium concentration n-type semiconductor layer; a low concentration n-type semiconductor layer formed on the second medium concentration n-type semiconductor layer; and a p-type semiconductor layer formed on the low concentration n-type semiconductor layer, is manufactured. This manufacturing method includes: growing the second medium concentration n-type semiconductor layer on an n-type semiconductor substrate by epitaxial growth; growing the low concentration n-type semiconductor layer on the second medium concentration n-type semiconductor layer by epitaxial growth, wherein a concentration of n-type impurities in the low concentration n-type semiconductor layer is lower than those in the n-type semiconductor substrate and the second medium concentration n-type semiconductor layer; and forming the high concentration n-type semiconductor layer by injecting n-type impurities to a lower surface of the n-type semiconductor substrate, wherein a concentration of n-type impurities in the high concentration n-type semiconductor layer is higher than that in the second medium concentration n-type semiconductor layer.

In the second manufacturing method, the step of forming the high concentration n-type semiconductor layer may be executed before the step of forming the second medium concentration n-type semiconductor layer by epitaxial growth, or may be executed between the step of growing the second medium concentration n-type semiconductor layer by epitaxial growth and the step of growing the low concentration n-type semiconductor layer by epitaxial growth, or may be executed after the step of growing the low concentration n-type semiconductor layer by epitaxial growth. The p-type semiconductor layer may be formed by either the epitaxial growth or the impurity injection. The step of forming the p-type semiconductor layer must be executed after the step of forming the low concentration n-type semiconductor layer, but may be executed before the step of forming the high concentration n-type semiconductor layer or may be executed after this step.

In the second manufacturing method, a region in the n-type semiconductor substrate that is other than the high concentration n-type semiconductor layer becomes the first medium concentration n-type semiconductor layer. The thickness of the first medium concentration n-type semiconductor layer is determined depending on the thickness of the n-type semiconductor substrate to be used. Therefore, it is easy to increase the thickness of the first medium concentration n-type semiconductor layer. According to the second manufacturing method, a diode including the first medium concentration n-type semiconductor layer and the second medium concentration n-type semiconductor layer can be manufactured. Variation in the concentration of the n-type impurities in the first medium concentration n-type semiconductor layer, which is formed of the n-type semiconductor substrate, is large, but the concentration of n-type impurities in the second medium concentration n-type semiconductor layer formed by the epitaxial growth can be accurately controlled. If the concentration of n-type impurities in the second medium concentration n-type semiconductor layer is controlled to be a concentration with which a depletion layer can be stopped, then the depletion layer stops at the second medium concentration n-type semiconductor layer when the diode is switched from the state where the forward voltage is applied to the state where the reverse voltage is applied. Since the variation in the concentration of n-type impurities in the second medium concentration n-type semiconductor layer is small, the variation in the range in which the depletion layer spreads is small. Consequently, the characteristics of the recovery surge voltage hardly vary among the diodes to be manufactured. Furthermore, the depletion layer does not reach an area inside the first medium concentration n-type semiconductor layer, hence, the carriers remain in the first medium concentration n-type semiconductor layer, and rapid exhaustion of the carriers does not occur. As a result, high recovery surge voltage is not generated. Consequently, according to the second manufacturing method, diodes, having low recovery surge voltage upon applying reverse voltage, and having the variation in characteristics of the recovery surge voltage is small, can be manufactured.

According to the second manufacturing method, the second medium concentration n-type semiconductor layer and the low concentration n-type semiconductor layer must be formed by the epitaxial growth. However, compared with a conventional manufacturing method in which the entire medium concentration n-type semiconductor layer and the low concentration n-type semiconductor layer are formed by the epitaxial growth, the second manufacturing method allows manufacturing diodes efficiently.

In the second manufacturing method, it is preferable to form the second medium concentration n-type semiconductor layer in which the concentration of n-type impurities is higher than that in the n-type semiconductor substrate.

The present specification also provides a diode of which recovery surge voltage upon applying reverse voltage is low, and the manufacturing variation in the recovery surge voltage to be generated is small. The diode includes: a high concentration n-type semiconductor layer; a first medium concentration n-type semiconductor layer formed on the high concentration n-type semiconductor layer; a second medium concentration n-type semiconductor layer formed on the first medium concentration n-type semiconductor layer; a low concentration n-type semiconductor layer formed on the second medium concentration n-type semiconductor layer; and a p-type semiconductor layer formed on the low concentration n-type semiconductor layer. A concentration NH of n-type impurities in the high concentration n-type semiconductor layer, a concentration NM1 of n-type impurities in the first medium concentration n-type semiconductor layer, a concentration NM2 of n-type impurities in the second medium concentration n-type semiconductor layer, and a concentration NL of n-type impurities in the low concentration n-type semiconductor layer satisfy a relationship of NL<NMl<NM2<NH.

When the reverse voltage is applied to this diode, the depletion layer stops at the second medium concentration n-type semiconductor layer in which the concentration of n-type impurities is high, and the depletion layer does not reach the first medium concentration n-type semiconductor layer. Therefore, the recovery surge voltage generated when the reverse voltage is applied is low.

BRIEF DESCRIPTION OF DRAWINGS

FIG. 1 shows a schematic cross-sectional view of a diode 10 and a diagram depicting a distribution of a concentration $N_d$ of impurities in each silicon layer;

FIG. 2 is a cross-sectional view of a silicon wafer 30;
FIG. 3 is a cross-sectional view of a wafer 32 after a low concentration drift layer 16 is formed;
FIG. 4 is a cross-sectional view of the wafer 32 after an anode layer 18 is formed;
FIG. 5 is a cross-sectional view of the wafer 32 after a lower surface is polished;
FIG. 6 is a cross-sectional view of the wafer 32 after a cathode layer 12 is formed;
FIG. 7 shows a schematic cross-sectional view of a diode 40 and a diagram depicting a distribution of a concentration $N_d$ of impurities in each silicon layer;
FIG. 8 is a cross-sectional view of a wafer 52 after a second medium concentration drift layer 44b is formed; and
FIG. 9 is a cross-sectional view of the wafer 52 after a low concentration drift layer 46 is formed.

DETAINED DESCRIPTION OF THE PREFFERED EMBODIMENT

(First embodiment)

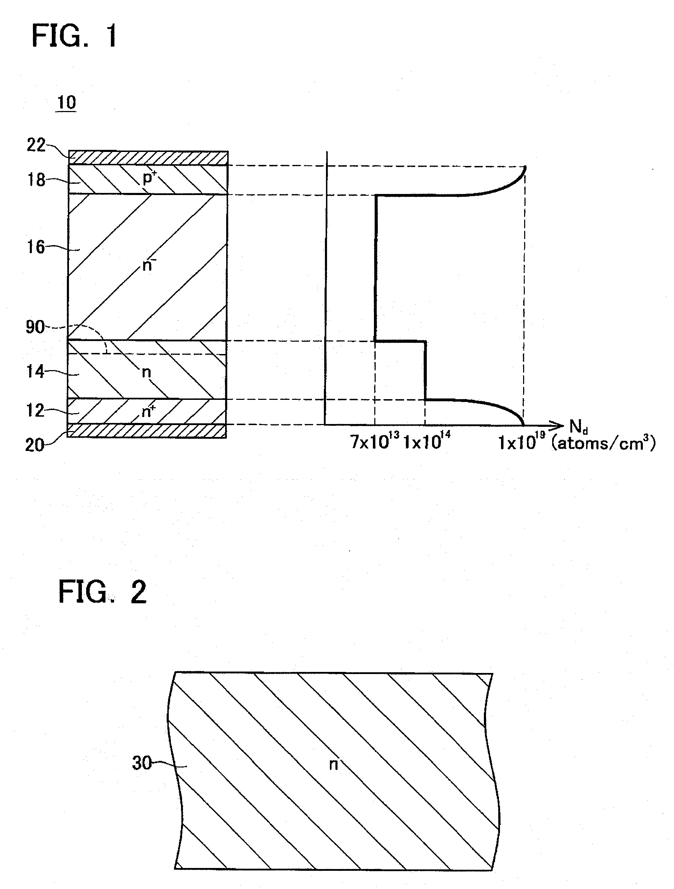

Fig. 1(a) shows a schematic cross-sectional view of a diode 10. As Fig. 1(a) shows, the diode 10 has a cathode layer 12, a medium concentration drift layer 14, a low concentration drift layer 16 and an anode layer 18. The cathode layer 12, the medium concentration drift layer 14 and the low concentration drift layer 16 are n-type silicon layers. The anode layer 18 is a p-type silicon layer. The medium concentration drift layer 14 is formed on the cathode layer 12. The low concentration drift layer 16 is formed on the medium concentration drift layer 14. The anode layer 18 is formed on the low concentration drift layer 16. The diode 10 further has an anode electrode 22 formed on an upper surface of the anode layer 18, and a cathode electrode 20 formed on a lower surface of the cathode layer 12.

Fig. 1(b) shows a distribution of a concentration $N_d$ of impurities in the silicon layers 12 to 18. In Fig. 1(b), the concentration of n-type impurities is shown for the cathode layer 12, the medium concentration drift layer 14 and the low concentration drift layer 16, and the concentration of p-type impurities is shown for the anode layer 18. As Fig. 1(b) shows, the concentration of n-type impurities in the cathode layer 12 is high, and the cathode layer 12 is connected to the cathode electrode 20 by ohmic connection. The concentration of n-type impurities in the medium concentration drift layer 14 is lower than that in the cathode layer 12. The concentration of n-type impurities in the low concentration drift layer 16 is lower than that in the medium concentration drift layer 14. The concentration of p-type impurities in the anode layer 18 is high, and the anode layer 18 is connected to the anode electrode 22 by ohmic connection. In the present embodiment, the concentration of n-type impurities in the cathode layer 12 is approximately $1 \times 10^{19}$ atoms/cm$^3$, the concentration of n-type impurities in the medium concentration drift layer 14 is approximately $1 \times 10^{14}$ atoms/cm$^3$, the concentration of n-type impurities in the low concentration drift layer 16 is approximately $7 \times 10^{13}$ atoms/cm$^3$, and the concentration of p-type impurities in the anode layer 18 is approximately $1 \times 10^{19}$ atoms/cm$^3$.

An operation of the diode 10 upon reverse recovery will now be described. When the diode 10 is switched from a state where forward voltage is applied to a state where reverse voltage is applied, a depletion layer spreads in the low concentration drift layer 16 from a p-n junction at a boundary of the low concentration drift layer 16 and the anode layer 18. By the depletion layer spreading into the low concentration drift layer 16, carriers, which existed in the low concentration drift layer 16 while the forward voltage was applied, are exhausted. In other words, holes are exhausted to the anode electrode 22, and electrons are exhausted to the cathode electrode 20. Due to this, the reverse current flows through the diode 10. At this time, since the concentration of n-type impurities of the medium concentration drift layer 14 is relatively high, the depletion layer hardly spread in the medium concentration drift layer 14. Therefore, after the depletion layer spreads in the low concentration drift layer 16, the depletion layer then stops in the medium concentration drift layer 14. In other words, the spread of the depletion layer stops at a position indicated by the dotted line 90 in Fig. 1. As a consequence, the depletion layer does not spread into the medium concentration drift layer 14 in the portion lower than the dotted line 90, and carriers remain in the medium concentration drift layer 14 in a portion lower than the dotted line 90. Hence rapid exhaustion of carriers is suppressed. The reverse current attenuates as the exhaustion of carriers progresses. An induced electromotive force is generated by a parasitic inductor of the diode 10 when the reverse current attenuates. This induced electromotive force becomes the recovery surge voltage. The faster the attenuation speed of the reverse current is, the larger the recovery surge voltage is. In the diode 10, the attenuation speed of the reverse current is slow, since the rapid exhaustion of carriers is suppressed. Consequently, a high recovery surge voltage is hardly generated in the diode 10.

A method of manufacturing the diode 10 will now be described. The diode 10 is manufactured from a silicon wafer 30 shown in Fig. 2. The silicon wafer 30 is made of n-type silicon. A concentration of n-type impurities in the silicon wafer 30 is approximately the same as the concentration of n-type impurities in the medium concentration drift layer 14. A thickness of the silicon wafer 30 is approximately 600 $\mu$m.

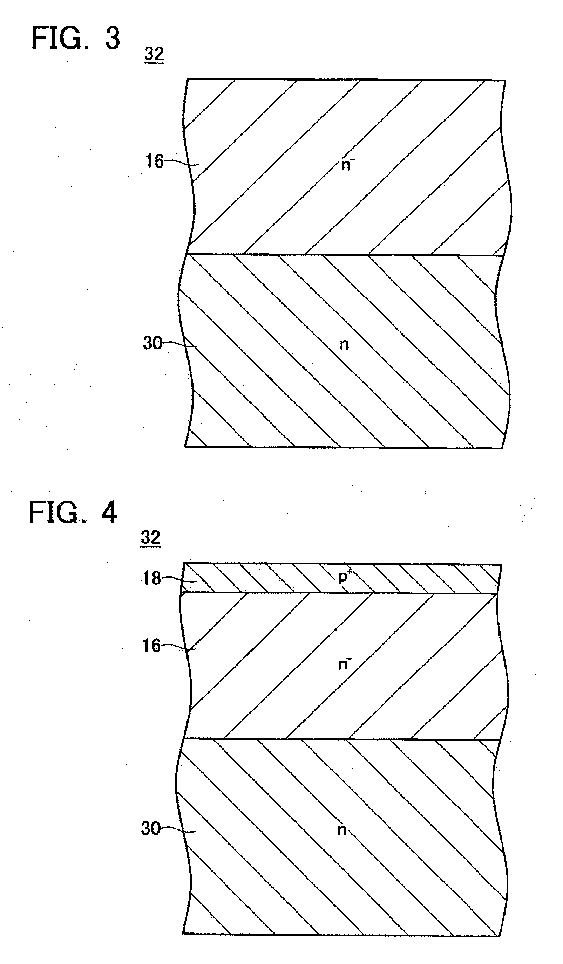

First as Fig. 3 shows, the low concentration drift layer 16 is grown on the silicon wafer 30 by epitaxial growth. Here, the low concentration drift layer 16 is formed with an approximately 100 $\mu$m thickness. The low concentration drift layer 16 is formed so as to have a concentration of n-type impurities lower than that of the silicon wafer 30. Hereafter the silicon wafer 30 and the layers formed on the surface of the silicon wafer 30 (i.e., the low concentration drift layer 16 and various layers formed in the following steps) are collectively called a "wafer 32".

Then p-type impurities are injected to an upper surface of the low concentration drift layer 16, and the wafer 32 is heat-treated. As Fig. 4 shows, due to this, a region near the upper surface of the low concentration drift layer 16 becomes p-type, and the anode layer 18 is formed. Then a withstand voltage structure, which is not illustrated, is formed on the upper surface of the wafer 32. Furthermore, the anode electrode 22 is formed on the upper surface of the wafer 32.

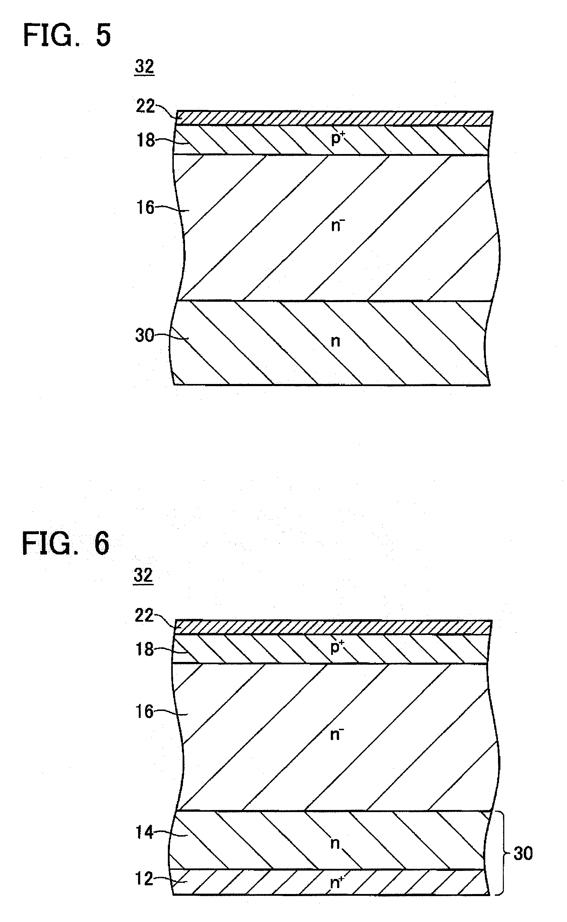

After the anode electrode 22 is formed, the lower surface of the silicon wafer 30 is polished so as to make the silicon wafer 30 thinner, as shown in Fig. 5. Here the polishing is performed until the thickness of the silicon wafer 30 becomes approximately 30 $\mu$m.

Then n-type impurities, such as arsenic and phosphorus, are injected to the lower surface of the silicon wafer 30, and the wafer 32 is heat-treated. As Fig. 6 shows, due to this, a concentration of n-type impurities in a region near the lower surface of the silicon wafer 30 increases, and the cathode layer 12 is formed. A region which is within the silicon wafer 30 and did not become the cathode layer 12 becomes the medium concentration drift layer 14, in which a concentration of n-type impurities is lower than that in the cathode layer 12, and is higher than that in the low concentration drift layer 16.

Then the cathode electrode 20 is formed on the lower surface of the wafer 32. Next, the wafer 32 is separated by dicing and the diode 10, shown in Fig. 1(a), is completed.

As described above, according to the method of manufacturing the diode 10 of the first embodiment, only the low concentration drift layer 16 is grown by the epitaxial growth. Therefore the epitaxial growth does not require a long time. Since the layer grown by the epitaxial growth is not so thick, defects hardly occur. As a consequence, the diodes 10 can be manufactured efficiently. Furthermore, according to the manufacturing method of the first embodiment, the medium concentration drift layer 14 is formed using the silicon wafer 30. Hence the medium concentration drift layer 14 having a sufficient thickness to suppress the recovery surge voltage can be formed.

Furthermore, according to the method of manufacturing the diode 10 of the first embodiment, the cathode layer 12 is formed by ion injection, therefore the concentration of n-type impurities in the cathode layer 12 can be increased. As a result, contact resistance between the cathode layer 12 and the cathode electrode 20 can be decreased.

According to the first manufacturing method of Japanese Patent Application Laid-Open No. 2000-228404 (the manufacturing method using the epitaxial growth), a semiconductor wafer, having a concentration of n-type impurities as high as that in the cathode layer, is used. In order to manufacture a semiconductor wafer in which the concentration of n-type impurities is high, arsenic must be used as the n-type impurities. In the case of using a semiconductor wafer containing a high concentration of arsenic, if the lower surface of the semiconductor wafer is polished in a step of manufacturing diodes, a waste containing toxic arsenic is generated. Furthermore, if a layer is grown by the epitaxial growth on the semiconductor wafer containing a high concentration of arsenic, a phenomenon of arsenic being introduced into the grown layer (normally called an "auto dope") is generated, and due to this, the characteristics of the grown layer cannot be controlled accurately. In the case of the manufacturing method of the first embodiment, the concentration of n-type impurities in the silicon wafer 30 is not so high, hence arsenic need not be used for the n-type impurities in the silicon wafer 30. If arsenic is not used, the above mentioned problems do not occur. Even if arsenic is used, the above mentioned problems hardly occur since the concentration of arsenic is low.

(Second embodiment)

In the diode 10 manufactured according to the above mentioned manufacturing method of the first embodiment, the medium concentration drift layer 14 is formed using the silicon wafer 30. The manufacturing variation in the concentration of n-type impurities in the silicon wafer 30 is large. Therefore the concentration of n-type impurities in the medium concentration drift layer 14 varies among the diodes 10 to be manufactured. Hence a manufacturing variation in the stop position of the depletion layer (that is, the position of the dotted line 90 in Fig. 1(a)) increases. As a result, the magnitude of the recovering surge voltage varies among the diodes to be manufactured.

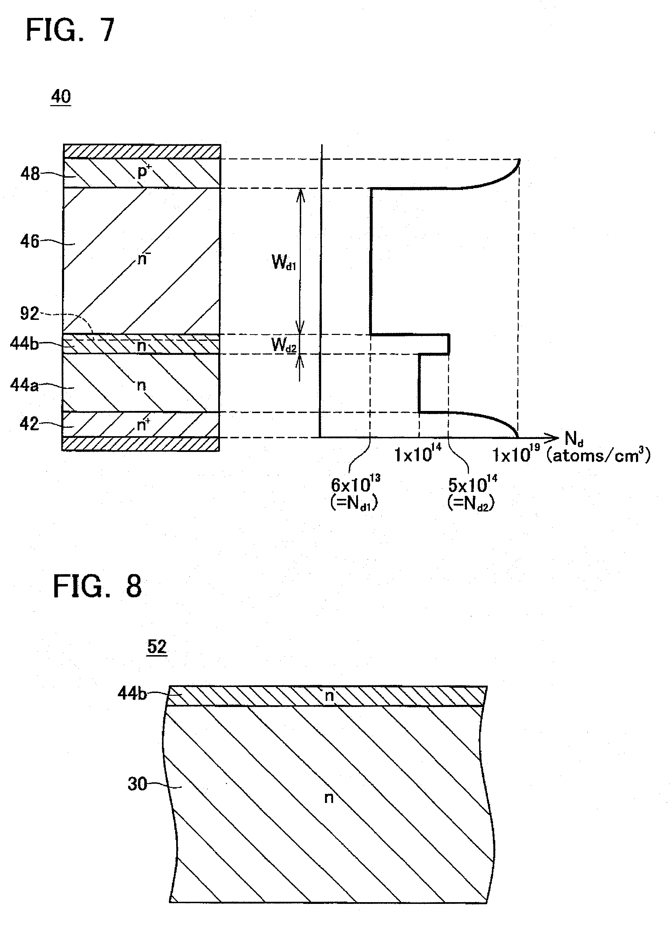

The second embodiment provides a manufacturing method for suppressing the manufacturing variation in the recovery surge voltage. According to the manufacturing method of the second embodiment, a diode 40 shown in Fig. 7(a) is manufactured. As Fig. 7(a) shows, in the diode 40, a medium concentration drift layer is comprised of a first medium concentration drift layer 44a and a second medium concentration drift layer 44b. The rest of the configuration is the same as that of the diode 10 of the first embodiment.

Fig. 7(b) shows a concentration $N_d$ of impurities in silicon layers 42 to 48. In Fig. 7(b), the concentration of n-type impurities is shown for a cathode layer 42, the first medium concentration drift layer 44a, the second medium concentration drift layer 44b, and a low concentration drift layer 46, and the concentration of p-type impurities is shown for an anode layer 48. As Fig. 7(b) shows, the concentrations of impurities in the cathode layer 42, the low concentration drift layer 46 and the anode layer 48 are approximately the same as those of the diode 10 of the first embodiment. The concentrations of n-type impurities in the first medium concentration drift layer 44a and the second medium concentration drift layer 44b are lower than that in the cathode layer 42, and higher than that in the low concentration drift layer 46. The concentration of n-type impurities in the second medium concentration drift layer 44b is higher than that in the first medium concentration drift layer 44a. In the present embodiment, the concentration of n-type impurities in the cathode layer 42 is approximately $1 \times 10^{19}$ atoms/cm$^3$, the concentration of n-type impurities in the first medium concentration drift layer 44a is approximately $1 \times 10^{14}$ atoms/cm$^3$, the concentration of n-type impurities in the second medium concentration drift layer 44b is approximately $5 \times 10^{14}$ atoms/cm$^2$, the concentration of n-type impurities in the low concentration drift layer 46 is approximately $6 \times 10^{13}$ atoms/cm$^2$, and the concentration of p-type impurities in the anode layer 48 is approximately $1 \times 10^{19}$ atoms/cm$^2$.

The thicknesses of the low concentration drift layer 46 and the second medium concentration drift layer 44b described above are set so that a depletion layer stops in the second medium concentration drift layer 44b when reverse voltage is applied to the diode 40. Specifically, the thicknesses are set such that the following relational expression is satisfied.

$$W_{d1} + W_{d2} \geq \{(2 \cdot \varepsilon_0 \cdot \varepsilon_{Si} \cdot V_a)/(q \cdot N_{d0})\}^{1/2}$$

Here, a symbol $W_{d1}$ denotes the thickness of the low concentration drift layer 46, a symbol $W_{d2}$ denotes the thickness of the second medium concentration drift layer 44b, a symbol $\varepsilon_0$ denotes a permittivity in a vacuum, a symbol $\varepsilon_{Si}$ denotes a relative permittivity of the low concentration drift layer 46 and the second medium concentration drift layer 44b (relative permittivity of silicon in this embodiment), a symbol $V_a$ denotes a rated voltage of the diode 40 (reverse voltage applied when the diode 40 is used), a symbol q denotes an elementary charge, and a symbol $N_{d0}$ denotes an average value of the concentrations ofn-type impurities of the low concentration drift layer 46 and the second medium concentration drift layer 44b. The average impurity concentration $N_{d0}$ is given by the following expression.

$$N_{d0}=(N_{d1}\cdot W_{d1}+N_{d2}\cdot W_{d2})/(W_{d1}+W_{d2})$$

Here, a symbol $N_{d1}$ denotes a concentration of n-type impurities in the low concentration drift layer 46, and a symbol $N_{d2}$ denotes a concentration of n-type impurities in the second medium concentration drift layer 44b.

As described in detail later, since the first medium concentration drift layer 44a is formed of a silicon wafer, the manufacturing variation in the concentration of n-type impurities in the first medium concentration drift layer 44a is large. On the other hand, since the second medium concentration drift layer 44b is an epitaxial layer, the manufacturing variation in the concentration of n-type impurities in the second medium concentration drift layer 44b is very small.

An operation of the diode 40 upon reverse recovery will now be described. When the diode 40 is switched from a state where forward voltage is applied to a state where reverse voltage is applied, a depletion layer spreads into the low concentration drift layer 46 from a p-n junction at a boundary of the low concentration drift layer 46 and the anode layer 48. The spread of the depletion layer stops in the second medium concentration drift layer 44b. In other words, the spread of the depletion layer stops at a position indicated by the dotted line 92 in Fig. 7(a). As a consequence, the depletion layer does not spread into the first medium concentration drift layer 44a, and carriers remain in the first medium concentration drift layer 44a. Consequently, high recovery surge voltage is hardly generated in the diode 40.

As mentioned above, the second medium concentration drift layer 44b is an epitaxial layer, therefore the manufacturing variation in the concentration of n-type impurities in the second medium concentration drift layer 44b is not large. As a consequence, the manufacturing variation in the stop position of the depletion layer indicated by the dotted line 92 hardly occurs. Hence in the diode 40, the manufacturing variation in the magnitude of the recovery surge voltage is suppressed.

A method of manufacturing the diode 40 will now be described. Just like the diode 10 of the first embodiment, the diode 40 is manufactured from the silicon wafer 30 shown in Fig. 2.

First as Fig. 8 shows, the second medium concentration drift layer 44b is grown on the silicon wafer 30 by epitaxial growth. Here the second medium concentration drift layer 44b is formed with an approximately 10 $\mu$m thickness. Furthermore, the second medium concentration drift layer 44b is formed so as to have a concentration of n-type impurities that is higher than that in the silicon wafer 30. Hereafter the silicon wafer 30 and the layers formed on the surface of the silicon wafer 30 (i.e., the second medium concentration drift layer 44b and various layers formed in the following steps) are collectively called a "wafer 52".

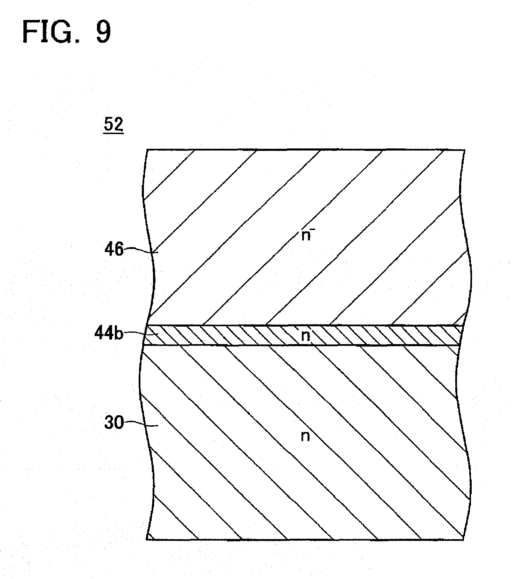

Then, as Fig. 9 shows, the low concentration drift layer 46 is grown on the second medium concentration drift layer 44b by epitaxial growth. Here the low concentration drift layer 46 is formed with an approximately 90 $\mu$m thickness. Furthermore, the low concentration drift layer 46 is formed so as to have a concentration of n-type impurities lower than that in the silicon wafer 30.

Then, just like the first embodiment, the anode layer 48 is formed, the anode electrode 22 is formed, the lower surface of the silicon wafer 30 is polished, the cathode layer 42 is formed, and the cathode electrode 20 is formed. A region which is within the silicon wafer 30 and did not become the cathode layer 42 becomes the first medium concentration drift layer 44a. Next, the wafer 52 is separated by dicing and the diode 40, shown in Fig. 7 (a), is completed.

As described above, according to the method of manufacturing the diode 40 of the second embodiment, the second medium concentration drift layer 44b is formed by epitaxial growth. The epitaxial growth can accurately control the concentration of n-type impurities in the second medium concentration drift layer 44b. Hence the variation in the stop position of the depletion layer, when the reverse voltage is applied to the diode 40 (that is, the position of the dotted line 92 in Fig. 7(a)), hardly occur. According to the manufacturing method of the second embodiment, the diodes 40, among which recovery surge voltage does not vary much, can be manufactured. As a result of a simulation performed for verifying a variation range of the recovery surge voltage generated due to the manufacturing variation in the concentration of n-type impurities in the silicon wafer 30, the variation range of the recovery surge voltage in the diodes 10 of the first embodiment is 152 V, while the variation range of the recovery surge voltage in the diodes 40 of the second embodiment is 43 V. Furthermore, by suppressing the variation in the stopping position of the depletion layer, variation in the withstand characteristics for reverse voltage among the diodes 40 is also decreased. As a result of a simulation performed for verifying a variation range of the withstand voltage due to the manufacturing variation in the concentration of n-type impurities in the silicon wafer 30, a variation range of the withstand voltage in the diodes 10 of the first embodiment is 207 V, while the variation range of the withstand voltage in the diodes 40 of the second embodiment is 126 V. Thus according to the manufacturing method of the second embodiment, even if the concentration of n-type impurities in the silicon wafer 30 varies, diodes 40 having stable characteristics can be manufactured.

According to the manufacturing method of the second embodiment, the first medium concentration drift layer 44a is formed of the silicon wafer 30, and the low concentration drift layer 46 and the second medium concentration drift layer 44b are formed by the epitaxial growth. Since the layer to be formed by the epitaxial growth is not so thick, the manufacturing method of the second embodiment allows manufacturing the diodes 40 efficiently. In the case of the manufacturing method of the second embodiment also, the problem of arsenic does not occur, just like the manufacturing method of the first embodiment.

Note that in the case of the above mentioned diode 40 of the second embodiment, the concentration of n-type impurities in the second medium concentration drift layer 44b is higher than that in the first medium concentration drift layer 44a. In order to stop the depletion layer, the higher concentration of n-type impurities in the second medium concentration drift layer 44b is preferable. However, if the depletion layer can be stopped in the second medium concentration drift layer 44b, the concentration of n-type impurities in the second medium concentration drift layer 44b may be lower than that in the first medium concentration drift layer 44a. With this configuration as well, the effect of decreasing the variation in the recovery surge voltage can be obtained if the second medium concentration drift layer 44b is an epitaxial layer. In other words, it is sufficient if an epitaxial layer, for stopping the spread of the depletion layer upon applying reverse voltage, is formed in the drift layer.

The technical elements described in the present specification and the drawings exhibit technical utility individually or by various combinations thereof, and are not limited to the combinations stated in the Claims in the application. The technology described in the present specification or the drawings is for achieving a plurality of purposes simultaneously, and has technical utility by achieving one of these purposes.

## Claims

1. A method of manufacturing a diode, the diode including a high concentration n-type semiconductor layer; a medium concentration n-type semiconductor layer formed on the high concentration n-type semiconductor layer; a low concentration n-type semiconductor layer formed on the medium concentration n-type semiconductor layer, and a p-type semiconductor layer formed on the low concentration n-type semiconductor layer,
the method comprising:

   growing the low concentration n-type semiconductor layer on an n-type semiconductor substrate by epitaxial growth, wherein a concentration of n-type impurities in the low concentration n-type semiconductor layer is lower than that in the n-type semiconductor substrate; and
   forming the high concentration n-type semiconductor layer by injecting n-type impurities to a lower surface of the n-type semiconductor substrate.

2. A method of manufacturing a diode, the diode including a high concentration n-type semiconductor layer; a first medium concentration n-type semiconductor layer formed on the high concentration n-type semiconductor layer; a second medium concentration n-type semiconductor layer formed on the first medium concentration n-type semiconductor layer; a low concentration n-type semiconductor layer formed on the second medium concentration n-type semiconductor layer; and a p-type semiconductor layer formed on the low concentration n-type semiconductor layer,
the method comprising:

   growing the second medium concentration n-type semiconductor layer on an n-type semiconductor substrate by epitaxial growth;
   growing the low concentration n-type semiconductor layer on the second medium concentration n-type semiconductor layer by epitaxial growth, wherein a concentration of n-type impurities in the low concentration n-type semiconductor layer is lower than those in the n-type semiconductor substrate and the second medium concentration n-type semiconductor layer; and
   forming the high concentration n-type semiconductor layer by injecting n-type impurities to a lower surface of the n-type semiconductor substrate, wherein a concentration of n-type impurities in the high concentration n-type semiconductor layer is higher than that in the second medium concentration n-type semiconductor layer.

3. The method of manufacturing the diode as in claim 2, wherein the second medium concentration n-type semiconductor layer, in which the concentration of n-type impurities is higher than that in the n-type semiconductor substrate, is formed.

4. A diode comprising:

   a high concentration n-type semiconductor layer;
   a first medium concentration n-type semiconductor layer formed on the high concentration n-type semiconductor layer,

a second medium concentration n-type semiconductor layer formed on the first medium concentration n-type semiconductor layer;

a low concentration n-type semiconductor layer formed on the second medium concentration n-type semiconductor layer; and

a p-type semiconductor layer formed on the low concentration n-type semiconductor layer, wherein a concentration NH of n-type impurities in the high concentration n-type semiconductor layer, a concentration NM1 of n-type impurities in the first medium concentration n-type semiconductor layer, a concentration NM2 of n-type impurities in the second medium concentration n-type semiconductor layer, and a concentration NL of n-type impurities in the low concentration n-type semiconductor layer satisfy a relationship of NL<NM1<NM2<NH.

FIG. 1

FIG. 2

# FIG. 3

<u>32</u>

16

$n^-$

30

n

# FIG. 4

<u>32</u>

18

$p^+$

16

$n^-$

30

n

## FIG. 5

## FIG. 6

# FIG. 7

<u>40</u>

# FIG. 8

<u>52</u>

# FIG. 9

**INTERNATIONAL SEARCH REPORT**

| International application No. |
| --- |
| PCT/JP2009/059759 |

A.  CLASSIFICATION OF SUBJECT MATTER
*H01L21/329*(2006.01)i, *H01L29/861*(2006.01)i

According to International Patent Classification (IPC) or to both national classification and IPC

B.  FIELDS SEARCHED

Minimum documentation searched (classification system followed by classification symbols)
H01L21/329, H01L29/861

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>Y | JP 2007-158320 A  (Fuji Electric Device<br>Technology Co., Ltd.),<br>21 June, 2007 (21.06.07),<br>Figs. 1, 2<br>& US 2007/0108558 A1<br>Figs. 1, 2 | 1<br>2-4 |
| X<br>Y | JP 2004-039842 A  (Fuji Electric Holdings Co.,<br>Ltd.),<br>05 February, 2004 (05.02.04),<br>Figs. 1, 2<br>(Family: none) | 1<br>2-4 |

| ☒ | Further documents are listed in the continuation of Box C. | ☐ | See patent family annex. |

| * | Special categories of cited documents: |
| --- | --- |
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>06 August, 2009 (06.08.09) | Date of mailing of the international search report<br>18 August, 2009 (18.08.09) |
| --- | --- |
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2009/059759

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP 2003-318412 A (Fuji Electric Co., Ltd.),<br>07 November, 2003 (07.11.03),<br>Figs. 33 to 35<br>& US 2004/0041225 A1<br>Figs. 44 to 46 | 1<br>2-4 |
| X<br>Y | JP 2003-152198 A (Fuji Electric Co., Ltd.),<br>23 May, 2003 (23.05.03),<br>Fig. 12<br>& US 2002/0130331 A1<br>Fig. 12 | 4<br>2-4 |
| X<br>A | JP 2000-223720 A (Meidensha Corp.),<br>11 August, 2000 (11.08.00),<br>Fig. 6<br>(Family: none) | 4<br>1-3 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000228404 A